# EUROPÄISCHE PATENTSCHRIFT

(11) **EP 0 722 570 B1**
(45) Veröffentlichungstag und Bekanntmachung des Hinweises auf die Patenterteilung: **22.07.1998**
(21) Anmeldenummer: 94926775.1
(22) Anmeldetag: 14.09.1994
(51) Int. Cl.: G01R 31/00

(54) **VORRICHTUNG ZUR EINSTELLUNG VON PARAMETERN UND/ODER BETRIEBSZUSTÄNDEN IN ELEKTRISCHEN WERKSTATTGERÄTEN**
DEVICE FOR REGULATING OPERATING PARAMETERS AND/OR CONDITIONS IN ELECTRICAL FACTORY EQUIPMENT
DISPOSITIF PERMETTANT D'AJUSTER DES PARAMETRES ET/OU DES REGIMES DANS DES APPAREILS ELECTRIQUES UTILISES EN ATELIER

(30) Priorität: 04.10.1993 DE 4333824
(43) Veröffentlichungstag der Anmeldung: 24.07.1996
(60) Teilanmeldung: 97100294.4
(73) Patentinhaber: ROBERT BOSCH GMBH, 70442 Stuttgart (DE)
(72) Erfinder: ANLAUF, Juergen, D-73035 Goeppingen (DE); ROTH, Rolf, D-73119 Zell u. A. (DE)
(86) Internationale Anmeldenummer: DE9401048
(87) Internationale Veröffentlichungsnummer: WO9510047

(56) Entgegenhaltungen:
- EP-A- 0 221 383
- WO-A-93/08654
- DE-A- 4 131 341

## Beschreibung

### Stand der Technik

Die Erfindung betrifft eine Vorrichtung zur Einstellung von Parametern und/oder Betriebszuständen in elektrischen Werkstattgeräten, insbesondere zur Sendefrequenzeinstellung in Sendemodulen zur Übertragung von Meßwerten.

Derartige, beispielsweise aus der DE-OS-35 38 687 oder der DE-OS-41 31 341 bekannte Vorrrichtungen werden zweckmäßigerweise überall dort eingesetzt, wo Meßwerte von einem bewegten Objekt, beispielsweise einem Fahrzeug, zu einer Auswertestation, beispielsweise einem Diagnosegerät, übertragen werden sollen. Eine bevorzugte Anwendung erfolgt bei der Kraftfahrzeug-Diagnose, bei der die unterschiedlichsten Meßwerte zur Echtzeit-Meßwertübertragung über eine Hochfrequenz-Funkverbindung übertragen werden. Beispielsweise müssen bei einem Bremsdruck-Meßsystem verschiedene Drücke an verschiedenen Stellen des Bremssystems erfaßt und zur Auswertung übertragen werden.

Diese als Sendemodule ausgebildeten Vorrichtungen müssen häufig nicht zuletzt auch in Abhängigkeit der örtlichen Gegebenheiten unter jeweils dort vorhandener elektromagnetischer Strahlung auf verschiedene Funkkanäle abgestimmt werden. Hierzu dienen in bekannter Weise beispielsweise DIP-Schalter. Die Sendemodule sind jedoch durch ihre Anbringung am Fahrzeug starker Beanspruchung unter anderem durch Schmutzwasser ausgesetzt, so daß eine sorgfältige Abdichtung des Modulgehäuses erforderlich ist. Dem steht die leichte Zugänglichkeit des DIP-Schalters als konträre Forderung gegenüber.

Auch bei anderen Werkstattgeräten, wie beispielsweise Eigendiagnosegeräten und Abgastestgeräten tritt diese Forderung auf, das Gerät möglichst hermetisch gegen Schmutz und Spritzwasser abzudichten, so daß Schalter zur Einstellung von Parametern oder Betriebszuständen möglichst zu vermeiden sind oder so geschützt eingebaut werden sollten, daß eine leichte Zugänglichkeit nicht mehr gegeben ist. Solche Einstellungen betreffen beispielsweise neben der Einstellung von Sendefrequenzen die Einstellung von Meßbereichen, Umschaltungen zwischen verschiedenen Meßwerterfassungen, Umschaltung zwischen Betriebszuständen (z. B. Ein/Aus) und dergleichen.

### Vorteile der Erfindung

Die erfindungsgemäße Vorrichtung mit den kennzeichnenden Merkmalen des Anspruchs 1 hat demgegenüber den Vorteil, daß auf Schalter weitgehend oder vollständig verzichtet werden kann und die nötigen Einstellungen von Parametern und/oder Betriebszuständen berührungslos über Infrarot-Strahlung erfolgen können. Das Werkstattgerät kann dadurch ein hermetisch abgedichtetes Gehäuse aufweisen, das keine überstehenden Schaltelemente oder dergleichen aufweist, die Ursache von Beschädigungen sein können.

Durch die in den Unteransprüchen aufgeführten Maßnahmen sind vorteilhafte Weiterbildungen und Verbesserungen der in dem Anspruch 1 angegebenen Vorrichtung möglich.

Bei einer Einstellung von Parametern oder Betriebszuständen oder Betriebszuständen über Infrarot-Signale kann das Gehäuse des Werkstattgeräts in einfacher Weise hermetisch abgeschlossen werden und braucht lediglich ein optisches Fenster zum Durchlaß der Infrarot-Signale aufweisen.

Zur Speicherung der durch die Einstellsignale vorgegebenen Parametern und/oder Betriebszustände eignet sich ein nichtflüchtiger Speicher im Werkstattgerät, der vorzugsweise als batteriegepuffertes RAM oder als EEPROM ausgebildet ist.

Um die vorgenommenen Einstellungen ablesen und überprüfen zu können, ist ein Display zur Wiedergabe dieser Parameter und Betriebszustände am Gehäuse des Werkstattgeräts von Vorteil.

Die vorliegende Erfindung eignet sich vor allem für als Sendemodule ausgebildete Werkstattgeräte, wobei die Steuereinrichtung als Umschalteinrichtung für verschiedene vorgegebene Sendefrequenzen ausgebildet ist. Das Gehäuse weist zur Übertragung von Meßwerten insbesondere Sensoren zur Erfassung dieser Meßwerte, wie Druck, Temperatur, Abgaszusammensetzung, Drehzahl oder dergleichen auf, deren Signale einer Sendeeinrichtung zugeführt werden.

### Zeichnung

Ausführungsbeispiele der Erfindung sind in der Zeichnung dargestellt und in der nachfolgenden Beschreibung näher erläutert. Es zeigen:
- Fig. 1: das Blockschaltbild eines Sendemoduls mit infrarot-gesteuerter Einstellung der Sendefrequenz,
- Fig. 2: eine Empfangsstation zum Empfang der vom Sendemodul übertragenen Meßwerte,
- Fig. 3: ein Infrarot-Einstellgerät zur drahtlosen Einstellung der Sendefrequenzen des Sendemoduls.

### Beschreibung der Ausführungsbeispiele

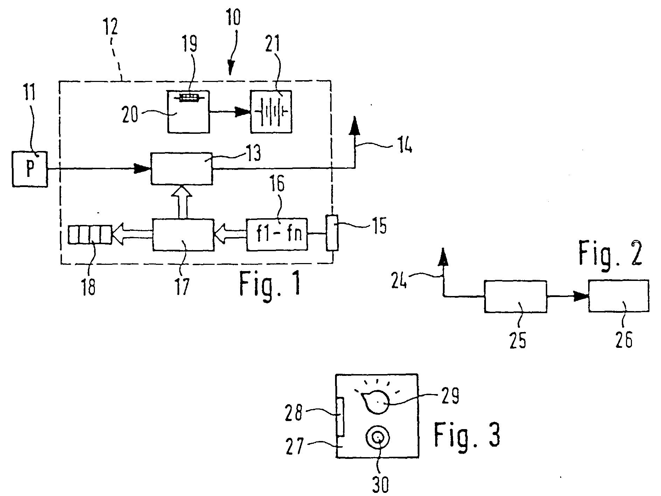

Das in Fig. 1 als erstes Ausführungsbeispiel dargestellte Sendemodul 10 besitzt einen Drucksensor 11 zur Erfassung beispielsweise des Bremsdrucks eines Lastkraftwagens, der überwacht oder überprüft werden soll. Hierzu werden üblicherweise mehrere derartige Sendemodule 10 an verschiedenen Stellen des Bremssystems eines Lastkraftwagens oder eines anderen Kraftfahrzeugs angebracht. Das Bremssystem weist hierzu entsprechende Meßöffnungen, insbesondere Schrauböffnungen auf, in die der Drucksensor oder eine mit einem Drucksensor verbundene Leitung eingeschraubt wird. Der Drucksensor 11 kann dabei am Gehäuse 12 des Sendemoduls angebracht oder mit diesem über eine Leitung verbunden sein. Mehrere solcher Sendemodule 10 dienen dabei zur Übertragung des Drucks an verschiedene Stellen, während ein weiteres Sendemodul 10 zur Erfassung eines Referenzdrucks dient und beispielsweise an einem Bremsdruck-Kupplungskopf des Lastkraftwagens angeordnet ist.

Der Drucksensor 11 ist dabei mit einer Sendestufe 13 im Inneren des Sendemoduls 10 verbunden, die einen Modulator besitzt, um das Meßsignal des Drucksensors 11 auf ein hochfrequentes Sendesignal aufzumodulieren, das über eine Antenne 14 abgestrahlt wird.

Eine Infrarot-Empfangseinrichtung 15, im folgenden vereinfacht als IR-Empfänger bezeichnet, ist beispielsweise als IR-Empfangsdiode ausgebildet und mit einer Decodiereinrichtung 16 verbunden, die in Abhängigkeit der empfangenen IR-Signale eine Umschaltung zwischen vorgesehenen Sendefrequenzen fl bis fn vornimmt und daher als Umschalteinrichtung wirkt. Ein einer angewählten Sendefrequenz entsprechendes Datenwort wird in einem nachgeschalteten Speicher 17 gespeichert, der dieses Datenwort zur Vorgabe der Sendefrequenz der Sendestufe 13 zuführt. Diese weist hierzu einen entsprechenden Umsetzer auf. Weiterhin wird dieses Datenwort einem Display 18 zugeführt, um die angewählte Sendefrequenz ablesen zu können.

Weiterhin besitzt das Sendemodul 10 noch eine mit einer Ladespule 19 versehene Ladeeinrichtung 20 zur Aufladung des aufladbaren Akkus 21, der in nicht dargestellter Weise zur Stromversorgung mit den einzelnen Komponenten des Sendemoduls 10 verbunden ist. Der Speicher 17 ist beispielsweise als RAM-Speicher ausgebildet und wird von diesem Akku 21 gepuffert, so daß er seinen Speicherinhalt immer behält. Anstelle eines batteriegepufferten RAM-Speichers kann auch beispielsweise ein EEPROM-Speicher treten. Der Ladestrom wird induktiv von einem Ladegerät, das ebenfalls eine Ladespule 23 besitzt, auf die Ladespule 19 der Ladeeinrichtung 20 übertragen. Selbstverständlich kann prinzipiell anstelle einer induktiven Aufladung eine Aufladung über ein Ladekabel und einen Ladestecker am Gehäuse 12 des Sendemoduls 10 treten.

In Fig. 2 ist eine Empfangsstation für die hochfrequent übertragenen Meßwerte dargestellt. Sie enthält eine mit einer Empfangsantenne 24 versehene Empfangsstufe 25, wobei die Empfangsstufe 25 wiederum einen nicht dargestellten Demodulator besitzt, über den das demodulierte Meßsignal einem Auswertegerät 26 zugeführt wird, das beispielsweise als Computer ausgebildet ist.

In Fig. 3 ist eine IR-Sendeeinrichtung 27 schematisch dargestellt. Sie besitzt einen IR-Sender 28, der beispielsweise als IR-Sendediode ausgebildet sein kann. Weiterhin besitzt diese IR-Sendeeinrichtung 27 ein Bedienungselement 29 zur Vorwahl der gewünschten Sendefrequenz, die im Sendemodul 10 eingestellt werden soll. Schließlich ist noch eine Sendetaste 30 zur Auslösung eines IR-Signals vorgesehen.

Prinzipiell können alle Sendemodule 10 mit derselben Sendefrequenz arbeiten, wobei dann eine zyklische Abfrage von Seiten der Empfangsstufe 25 oder ein zyklischer, synchronisierter Betrieb erforderlich ist. Andererseits ist es auch möglich, jedes Sendemodul 10 mit einer anderen Sendefrequenz zu beaufschlagen, wobei die Empfangsstufe 25 dann zum Empfang von Meßsignalen auf verschiedenen Kanälen ausgebildet ist. Auch wenn alle Sendemodule 10 mit derselben Sendefrequenz arbeiten, soll dennoch eine Kanalumschaltung dadurch erforderlich werden, wenn im aktuellen Frequenzkanal Störungen auftreten. Auch aus anderen Gründen kann eine Umschaltung erforderlich sein.

Soll die Sendefrequenz des Sendemoduls 10 das erste Mal vorgegeben werden oder eine vorgegebene Sendefrequenz geändert werden, so wird die gewünschte Sendefrequenz am Bedienungselement 29 eingestellt, das beispielsweise als Drehschalter oder als Tastatur ausgebildet ist. Mit Hilfe der Sendetaste 30 wird nun ein mit der entsprechenden Information versehenes IR-Signal, das beispielsweise moduliert sein kann, zum IR-Empfänger 15 abgesandt. Ein IR-durchlässiges Fenster im hermetisch abgeschlossenen Gehäuse 12 gestattet den Empfang dieses IR-Signals. In der Decodiereinrichtung 16 erfolgt die Decodierung des in ein elektrisches Signal umgewandelten IR-Signals, und ein bei gewünschter Frequenz entsprechendes Datenwort wird im Speicher 17 gespeichert und kann über das Display 18 wiedergegeben werden, so daß die eingestellte Frequenz abgelesen werden kann. Gleichzeitig wird über das gespeicherte Datenwort die neue Sendefrequenz in der Sendestufe 13 vorgegeben, so daß die gemessenen Druckwerte nur mit dieser neuen Frequenz zur Empfangsstation übertragen werden.

Auf diese Weise werden nacheinander alle verwendeten Sendemodule 10 auf die gewünschte Sendefrequenz eingestellt. Es ist auch möglich, mit Hilfe des IR-Senders 18 das Ein- und Ausschalten des Sendemoduls 10 zu bewirken oder noch andere Umschaltvorgänge auszuführen.

Anstelle einer induktiven Aufladung des Akkus 21 kann das Ladegerät selbstverständlich auch in herkömmlicher Weise den Ladestrom über ein Ladekabel dem Akku 21 zuführen. in diesem Falle ist die Ladeeinrichtung 20 als Ladestecker bzw. Ladebuchse ausgebildet.

Mit Hilfe der Codierung von Parametern und Betriebszuständen über Infrarotsignale gemäß dem Ausführungsbeispiel können derartig hermetisch abgeschlossene Gehäuse leicht realisiert werden, und die Schaltvorgänge, beispielsweise zum Umschalten von Meßbereichen, Meßwerterfassungen, Betriebszuständen (Ein/Aus) und dergleichen können entsprechend der beschriebenen Art der Umschaltung zwischen Sendefrequenzen vorgenommen werden.

## Patentansprüche

1. Vorrichtung zur Diagnose von Kraftfahrzeugen, mit einem Sendemodul (10) eines Werkstattgeräts, wobei das Sendemodul (10) von Sensoren erfaßte Meßwerte hochfrequent zu einer Empfangsstation überträgt, dadurch gekennzeichnet, daß das Sendemodul (10) eine Infrarot-Empfangseinrichtung (15) enthält, die mit einer Infrarot-Sendeeinrichtung (27) zusammenwirkt, daß die Infrarot-Sendeeinrichtung (27) Infrarot-Signale zur Einstellung von Parametern und/oder Betriebszuständen des Sendemoduls (10) bereitstellt und daß das Sendemodul (10) eine die empfangenen Infrarot-Einstellsignale in elektrische Schaltsignale zur Einstellung der entsprechenden Parameter und/oder Betriebszustände umsetzende Steuereinrichtung (16) enthält.

2. Vorrichtung nach Anspruch 1, dadurch gekennzeichnet, daß ein hermetisch abgeschlossenes Gehäuse (12) des Sendemoduls (10) ein optisches Fenster zum Durchlaß der Infrarot-Signale aufweist.

3. Vorrichtung nach Anspruch 1 oder 2, dadurch gekennzeichnet, daß das Sendemodul (10) zur Stromversorgung mit einem aufladbaren Akku (21) versehen ist, der induktiv über eine Ladespule (19) mittels eines separaten Ladegeräts aufladbar ist.

4. Vorrichtung nach einer der vorhergehenden Ansprüche, dadurch gekennzeichnet, daß ein nicht flüchtiger Speicher (17) zur Speicherung der durch die Einstellsignale vorgegebenen Parameter und/oder Betriebszustände enthalten ist.

5. Vorrichtung nach Anspruch 4, dadurch gekennzeichnet, daß der nicht flüchtige Speicher (17) als batteriegepuffertes RAM oder als EEPROM ausgebildet ist.

6. Vorrichtung nach Anspruch 4 oder 5, dadurch gekennzeichnet, daß ein Display (18) zur Wiedergabe der eingestellten Parameter und/oder Betriebszustände am Gehäuse (12) des Sendemoduls (10) angeordnet ist.

7. Vorrichtung nach einem der vorhergehenden Ansprüche, dadurch gekennzeichnet, daß die Steuereinrichtung (16) als Umschalteinrichtung für verschiedene vorgegebene Sendefrequenzen des Sendemoduls (10) ausgebildet ist.

8. Vorrichtung nach Anspruch 7, dadurch gekennzeichnet, daß das Gehäuse (12) Sensoren (11) zur Erfassung von Meßwerten, wie Druck, Temperatur, Abgaszusammensetzung, Drehzahl aufweist oder mit diesen verbunden ist, deren Signale einer Sendeeinrichtung (13) zugeführt werden.

## Claims

1. Device for diagnosing motor vehicles, having a transmission module (10) of a workshop unit, the transmission module (10) transmitting measured values sensed by sensors to a reception station at high frequency, characterized in that the transmission module (10) contains an infrared reception device (15) which interacts with an infrared transmission device (27), in that the infrared transmission device (27) makes available infrared signals for setting parameters and/or operating states of the transmission module (10), and in that the transmission module (10) contains a control device (16) which converts the received infrared setting signals into electrical switching signals for setting the corresponding parameters and/or operating states.

2. Device according to Claim 1, characterized in that a hermetically sealed housing (12) of the transmission module (10) has an optical window for the infrared signals to pass through.

3. Device according to Claim 1 or 2, characterized in that there is provision for the transmission module (10) to be supplied by power using a rechargeable battery (21) which can be charged inductively via a charging coil (19) by means of a separate charging unit.

4. Device according to one of the preceding claims, characterized in that a non-volatile memory (17) for storing the parameters and/or operating states provided by the setting signals is included.

5. Device according to Claim 4, characterized in that the non-volatile memory (17) is designed as a battery-buffered RAM or as an EEPROM.

6. Device according to Claim 4 or 5, characterized in that a display (18) for representing the parameters and/or operating states which have been set is arranged on the housing (12) of the transmission module (10).

7. Device according to one of the preceding claims, characterized in that the control device (16) is designed as a switch-over device for various prescribed transmission frequencies of the transmission module (10).

8. Device according to Claim 7, characterized in that the housing (12) has sensors (11) for sensing measured values such as pressure, temperature, exhaust-gas composition, rotational speed or is connected to said sensors (11) whose signals are fed to a transmission device (13).

## Revendications

1. Dispositif de diagnostic de véhicules automobiles comprenant un module d'émetteur (10) d'un appareil d'atelier, le module d'émetteur (10) transmettant vers une station de réception, par une liaison haute fréquence les grandeurs de mesure saisies par des capteurs
caractérisé en ce que
• le module d'émetteur (10) comporte une installation de réception infrarouge (15) coopérant avec une installation d'émetteur infrarouge (27),
• l'installation d'émetteur infrarouge (27) fournit des signaux infrarouges pour régler des paramètres et/ou des états de fonctionnement du module d'émetteur (10) et
• le module d'émetteur (10) comporte une installation de commande (16) qui convertit les signaux de réglage infrarouges reçus, en signaux de commutation électriques pour régler les paramètres correspondants et/ou les états de fonctionnement.

2. Dispositif selon la revendication 1,
caractérisé par
un boîtier (12) fermé de manière hermétique pour le module d'émetteur (10) et comportant une fenêtre optique pour le passage des signaux infrarouges.

3. Dispositif selon la revendication 1 ou 2,
caractérisé en ce que
le module d'émetteur (10) est muni d'un accumulateur déchargable (21) pour assurer l'alimentation électrique, l'accumulateur pouvant être chargé par induction par l'intermédiaire d'une bobine de chargement (19) à l'aide d'un chargeur séparé.

4. Dispositif selon des revendications précédentes,
caractérisé par
une mémoire non volatile (17) pour enregistrer les paramètres et/ou états de fonctionnement prédéterminés par les signaux de réglage.

5. Dispositif selon la revendication 4,
caractérisé en ce que
la mémoire non volatile (17) est une mémoire RAM alimentée par batterie ou une mémoire EEPROM.

6. Dispositif selon la revendication 4 ou 5;
caractérisé par
un moyen d'affichage (18) pour reproduire les paramètres réglés et/ou les états de fonctionnement du boîtier (12) du module d'émetteur.(10).

7. Dispositif selon l'une quelconque des revendications précédentes,
caractérisé en ce que
l'installation de commande (16) est constituée par une installation de commutation pour les différentes fréquences d'émission du module d'émetteur (10).

8. Dispositif selon la revendication 7
caractérisé en ce que
le boîtier (12) comporte des capteurs (11) pour saisir des grandeurs de mesure telles que la pression, la température, la composition des gaz d'échappement, la vitesse de rotation en étant relié à ces capteurs dont les signaux sont fournis à une installation d'émetteur (13).
